# EUROPEAN PATENT APPLICATION

(11) **EP 4 800 464 A1**
(43) Date of publication of application: **02.09.2026**
(21) Application number: 25160761.0
(22) Date of filing: 27.02.2025
(51) Int. Cl.: G02F 1/017, H01S 5/34

(54) **SINGLE PHOTON SOURCES**

(71) Applicant: Aegiq Ltd, Sheffield S1 2NS (GB)
(72) Inventor: FOSTER, Andrew, Sheffield, S1 2NS (GB); BROMLEY, Harry, Sheffield, S1 2NS (GB); GILLARD, George, Sheffield, S1 2NS (GB); OVENDEN-HALLETT, Charlotte, Sheffield, S1 2NS (GB); DUFFERWIEL, Scott, Sheffield, S1 2NS (GB)
(74) Representative: Mathys & Squire

(57) **Abstract**

An apparatus comprising: a photonic integrated circuit comprising: a photon emitter, and a single channel, arranged in-plane on the photonic integrated circuit, and arranged to direct excitation photons into the photon emitter and to carry away photons emitted from the photon emitter, wherein the wavelength of the excitation photons is detuned from the zero-phonon excitation and emission wavelength of the photon emitter.

## Description

### Field of Invention

This invention relates to single photon sources. More specifically, the invention relates to an apparatus comprising a photonic integrated circuit for providing a single photon source, a system comprising the photonic integrated circuits, and a method for generating single photons.

### Background

Single photon sources comprise a photon emitter which emits a single photon each time it is excited. Various types of single photon sources exist, and quantum dot-based devices have emerged as a primary source of high-quality indistinguishable single photons suitable for quantum applications such as quantum cryptography and optical quantum computing.

Typically, a pump laser is used to optically excite the photon emitter. For example, for a quantum dot or other solid state emitter, classical light from the pump laser is absorbed by the photon emitter to generate an exciton (i.e., an electron-hole pair) which will then probabilistically decay to release a single photon. The photon emitter will then require re-excitation before subsequent photons can be emitted. Classical light from the pump laser is required to excite the photon emitter, but it is critical that the light from the pump laser does not contaminate the single photon stream that is output from the photon emitter.

### Summary of the Invention

Aspects of the invention are set out in the independent claims and optional features are set out in the dependent claims. Aspects of the disclosure may be provided in conjunction with each other and features of one aspect may be applied to other aspects.

In one aspect there is provided an apparatus comprising a photonic integrated circuit comprising: a photon emitter, and a single channel, arranged in-plane on the photonic integrated circuit, and arranged to direct excitation photons into the photon emitter and to carry away photons emitted from the photon emitter, wherein the wavelength of the excitation photons is detuned from the zero-phonon excitation and emission wavelength of the photon emitter.

The in-plane arrangement of the single channel on the photonic integrated circuit may be provided by the single channel being arranged so that a length of the channel lies parallel with the surface of the photonic integrated circuit, such as on or at the surface or in a layer of the photonic integrated circuit beneath the surface.

The photon emitter may be arranged in the same plane as the single channel, in the sense that the photon emitter and the single channel are formed in the same plane as one another, and the plane may be the surface of the photonic integrated circuit or in layer of the photonic integrated circuit beneath the surface. The plane may be provided by a surface of a substrate upon which the photon emitter is formed.

In some examples, the photonic integrated circuit may not include any photonic processing componentry, such as optical interferometers. Any processing of the photons generated by the photon emitter may be carried out by a separate apparatus, for example by a further photonic integrated circuit with such processing capability. For example, the apparatus may comprise one or more further photonic integrated circuits comprising photonic processing componentry which are optically coupled (for example via an optical fibre) to the photonic integrated circuit comprising the photon emitter. In this way, photons generated by the photon emitter can be transfer to the further photonic integrated circuit(s) for processing.

In other examples, the photonic integrated circuit comprising the photon emitter may further comprise photonic processing componentry, such as an optical interferometer, for processing the photons generated by the photon emitter.

Advantageously, using the apparatus of the present disclosure, the photon emitter can be excited using excitation photons that have a different wavelength to the wavelength of the single photons emitted by the photon emitter, enabling the excitation photons and the single photons emitted by the photon emitter to be distinguished from one another. This in turn means that only a single channel need be provided for carrying the excitation photons to the photon emitter and carrying the single photons emitted by the photon emitter away from the photon emitter towards collection options. This is in contrast to a multi-channel approach, in which the pump laser input stream and single photon output stream are confined to spatially separated channels (e.g., separate waveguides) to avoid cross-contamination. The apparatus of the present disclosure - having a single pumping and collection channel - can therefore be made to have a smaller footprint, and to have a simpler design. The apparatus of the present disclosure can also make use of spectral filtering to distinguish between the pumping input stream photons and the photon output stream, which contrasts with a multi-channel system in which the wavelengths of the pumping and emitted photons would be the same.

Moreover, arranging the single channel in-plane on the photonic integrated circuit also gives rise to a number of advantages. Firstly, an in-plane channel is better suited for use with an in-plane cavity (in which the photon emitter is located on the photonic integrated circuit), and the emission lifetime of the photon emitter in an in-plane cavity can be shorter when compared to a micropillar cavity, for example. Secondly, standard fibre packaging components (such as fibre couplers) are typically designed for in-plane photonic components, meaning that the in-plane channel of the apparatus can be integrated more readily with existing fibre packaging, unlike other structures such as micropillars which require bespoke fibre packaging components due to the need for the excitation and emission waveguides to be arranged out of the plane of the photonic integrated circuit.

The single channel may be a single mode channel or a multi-mode channel. A single mode channel is preferable because it increases the efficiency of interactions with the photon emitter. However, it is also possible to have multiple mode channels. For example, the channel may be configured to carry modes with different polarisations (such as could allow laser excitation photons and emitted single photons to have different polarisations, even in a single channel).

The photon emitter may be a solid state photon emitter.

The wavelength of the excitation photons may be tuned to a phonon sideband excitation wavelength of the photon emitter. The wavelength of the excitation photons may be tuned to the phonon sideband excitation wavelength that is longer than the zero-phonon excitation wavelength. The wavelength of the excitation photons may be tuned to the phonon sideband excitation wavelength that is shorter than the zero-phonon excitation wavelength. Tuning the wavelength of the excitation photons to a phonon sideband excitation wavelength of the photon emitter leads to the absorption of the photons by the photon emitter via phonon-assisted energy level transitions of the photon emitter.

The apparatus, or at least the photonic integrated circuit of the apparatus, is preferably cooled, and the apparatus may comprise a heatsink or heat exchanger to provide the cooling. In one example, the apparatus may be cooled to 4 K. At low temperatures, the relatively small proportion of photons that are emitted by the photon emitter via a phonon-assisted transition (rather than the zero-phonon transition) will tend to be emitted via the sideband on the long wavelength side of the zero-phonon line (involving emission of a phonon and a lower-energy photon), because at low temperatures there are few phonons available to be absorbed by the photon emitter such as would be required to enable emission via the sideband on the short wavelength side of the zero-phonon line (which would require absorption of a phonon and emission of a higher-energy photon). For the same reason, at low temperatures the photon emitter may be excited via the short wavelength phonon sideband, which involves the photon emitter absorbing a higher-energy excitation photon and emitting a phonon, rather than the long wavelength phonon sideband, which would involve the phonon emitter absorbing a lower-energy excitation photon and absorbing a phonon (few of which would be available). In this way, the photon emitter can be excited by pumping via the short wavelength phonon sideband while emitting photons via the zero-phonon line (primarily) and the long wavelength phonon sideband (secondarily). Therefore, in this case it possible not only to distinguish (using spectral filtering) the excitation laser photons from the single photons emitted via the zero-phonon line, but also to distinguish the excitation laser photons from the single photons emitted via the long wavelength sideband.

The apparatus may comprise a light coupling structure to direct the excitation photons into the single channel and/or to direct the photons emitted from the photon emitter from the single channel to an output of the photonic integrated circuit. The light coupling structure couples the single channel to the pumping and/or collection optics.

The light coupling structure may comprise a circulator or an imbalanced beam splitter. The circulated or imbalanced beam splitter may provide a multi-port light coupling structure to guide pumping photons from a pumping laser to the single channel and to guide emitted single photons from the single channel to collection optics.

The light coupling structure may additionally or alternatively comprise: an outcoupler; an edge coupler; or an evanescent coupler. The outcoupler, edge coupler, or evanescent coupler may direct photons from the single channel out of plane of the photonic integrated circuit and to collection optics, or direct pumping photons from a laser into the plane of the photonic integrated circuit and into the single channel. Preferably, the single channel comprises the outcoupler, edge coupler, or evanescent coupler, for example the outcoupler, edge coupler, or evanescent coupler may be arranged at one end of the single channel, such as the opposite end of the single channel from the photon emitter.

The apparatus may comprise a spectral filter for wavelength filtering of photons output from the single channel. The spectral filter enables the pumping photons and single photons emitted from the photon emitter to be distinguished from one another - due to their different wavelengths - such that any pumping photons contaminating the output stream can be removed from the output stream. The spectral filter may be separate from the photonic integrated circuit, upon which the single channel is arranged. For example, the spectral filtering can be carried out "off chip" (i.e., off of the photonic integrated circuit).

The excitation photons may be laser photons, preferably laser photons from a pump laser. The laser may be a pulsed laser. Advantageously, using a pulsed laser to pump the photon emitter leads to deterministic output of single photons from the photon emitter.

The apparatus may comprise an optical cavity, in which the photon emitter is located, arranged to direct photons emitted from the photon emitter into the single channel. For example, the optical cavity may be configured such that there is a preferential direction in which photons emitted from the photon emitter will tend to leak out of the cavity (which may be, for example, directly back towards the single channel). The optical cavity may be located in the single channel, with the photon emitter located in the optical cavity. The optical cavity may be arranged in-plane on the photonic integrated circuit (that is, in the same plane in which the photon emitter and the single channel are arranged). The apparatus may also comprise at least one mirror arranged to direct photons emitted from the photon emitter into the single channel. Cavities can be used to selectively enhance decay processes, and in the apparatus of the present disclosure the cavity may be configured to enhance the rate of decay of the photon emitter via the zero-phonon line transition.

The single channel may be curved. Preferably, the curvature of the single channel may be such that the direction in which the photons emitted by the photon emitter enter the single channel at one end of the single channel is substantially perpendicular to the direction in which those photons exit the single channel at the other end of the single channel. Advantageously, the curved channel changes the polarisation of the single photons emitted from the photon emitter as they travel the curve of the single channel. In this way, by controlling the polarisation of the pumping photons used to excite the photon emitter, and arranging the pump laser such that the photon emitter is excited by a stream of excitation photons directed into the plane of the photonic integrated circuit, the pumping photons and single photons emitted from the photon emitter can also be distinguished from one another by polarisation filtering.

The single channel may be suspended upon the surface of the photonic integrated circuit. The apparatus may therefore comprise at least one mechanical support to support the suspended single channel, wherein the single channel comprises a widened portion at an interface between the single channel and the at least one mechanical support. As a light mode travelling along the single channel enters the widened portion of the channel, the light mode is modified due to the different dimensions of the channel at the point, making the light mode less sensitive to scattering as it passes the mechanical supports. This increases transmission of photons past the mechanical support, and reduces scattering loses caused by the support.

The single channel may be a free-space channel. Alternatively, or additionally, the single channel may comprise a waveguide. The waveguide may be formed as a section of unetched material on the photonic integrated circuit, such as a suspended strip of material, through which the photons are guided.

The photon emitter may be formed as a quantum dot, preferably an epitaxial quantum dot, embedded in a host lattice. The quantum dot may be formed from: InAs; or GaAs, and/or wherein the host lattice is formed from: GaAs; InP; or AlGaAs. Advantageously, longitudinal acoustic phonons in such lattices have energies on the order of a few meV, which are well suited to provided phonon-assisted energy level transitions in the quantum dot.

In one aspect there is provided a system comprising: an apparatus as aforementioned; and a laser configured to generate the excitation photons.

In one aspect there is provided a method for generating photons, comprising: directing, through a single channel arranged in-plane on a photonic integrated circuit, excitation photons into a photon emitter; carrying away, through the single channel, photons emitted from the photon emitter; and detuning the wavelength of the excitation photons from the zero-phonon excitation wavelength of the photon emitter.

In another aspect there is provided an apparatus comprising: a photon emitter, and a single channel, wherein the photon emitter and single channel are formed in the same plane as one another. The plane may be the surface of a chip. The single channel is arranged to direct excitation photons into the photon emitter and to carry away photons emitted from the photon emitter, wherein the wavelength of the excitation photons is detuned from the zero-phonon excitation and emission wavelength of the photon emitter.

In another aspect there is provided a method for generating photons, comprising: directing, through a single channel excitation photons into a photon emitter, wherein the photon emitter and single channel are formed in the same plane as one another; carrying away, through the single channel, photons emitted from the photon emitter; and detuning the wavelength of the excitation photons from the zero-phonon excitation wavelength of the photon emitter. The plane may be the surface of a chip.

Embodiments of the disclosure will now be described, by way of example only, with reference to the accompanying drawings, in which:
Figure 1 is an energy level diagram for a photon emitter; and
Figure 2 is a schematic diagram of an apparatus for generating single photons;

In the drawings like reference numerals indicate like elements.

### Specific description

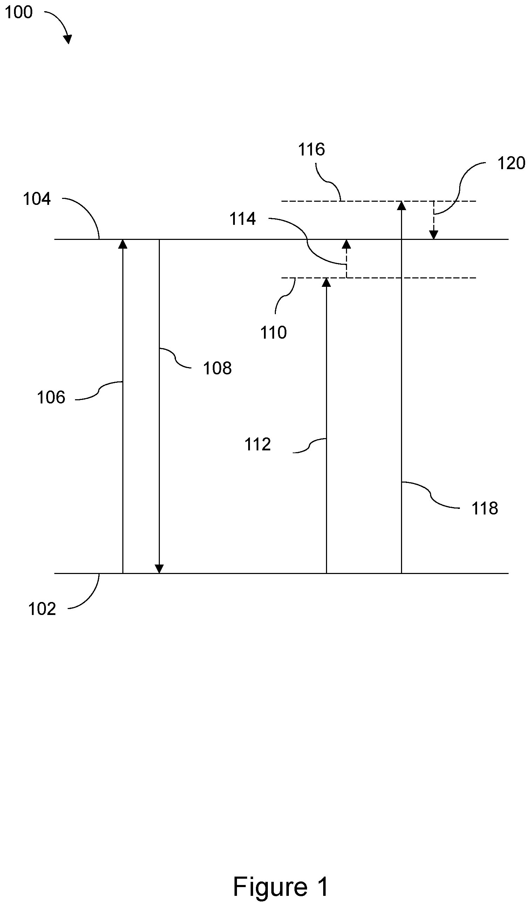

Figure 1 is an energy level diagram 100 for a photon emitter. The energy level structure includes a first energy level 102, which may represent a ground state of the photon emitter, and a second, higher energy level 104. The higher energy level 104 represents an excited state of the photon emitter in which a photon has been absorbed by the photon emitter to generate an exciton (i.e., an electron-hole pair). Arrows in Figure 1 illustrate exemplary translations between energy levels, where the photon emitter is excited from the lower energy level to the higher energy level by absorption of energy, or decays from the higher energy level to the lower energy level by emission of energy.

The photon emitter in this example is a quantum dot, which can absorb or emit phonons (quantised modes of vibrations) to provide phonon-assisted energy level transitions, whereby an interaction between the quantum dot and a phonon, in addition to the absorption or emission of a photon, enables the photon emitter to transition between energy levels via intermediate, virtual energy levels.

One way to achieve such phonon-assisted energy level transitions is to use an epitaxial quantum dot embedded in a host lattice, such that the quantum dot can interact with phonons (particularly longitudinal acoustic phonons) in the host lattice. However, other systems which enable phonon-assisted energy level transitions for the quantum dot are also possible.

A zero-phonon transition occurs when the photon emitter transitions between the first energy level 102 and the second energy level 104 by absorbing or emitting a photon having an energy corresponding to the energy gap between the first and second energy levels, without absorbing or emitting a phonon. For example, the photon emitter may transition 106 directly from the first energy level to the second energy level (by absorbing a photon to generate an exciton) or transition 108 directly from the second energy level 104 to the first energy level 102 (by emitting a photon upon decay of the exciton).

When a phonon-assisted transition occurs, the quantum dot transitions between the first and second energy levels via one or more intermediate, virtual energy levels by absorbing or emitting a phonon in addition to the photon.

In a first example, the photon emitter may transition from the first energy level 102 to the second energy level 104 via an intermediate virtual energy level 110 which is lower than the second energy level 104. In this example, the photon emitter absorbs a photon having an energy corresponding to the energy gap between the first energy level 102 and the intermediate energy level 110 enabling the photon emitter to transition 112 from the first energy level 102 to the intermediate virtual energy level 110, and the photon emitter absorbs a phonon having an energy corresponding to the energy gap between the virtual energy level 110 and the second energy level 104, enabling the photon emitter to transition 114 from the intermediate virtual energy level 110 to the second energy level 104. Therefore, in this first example, the photon emitter is excited using a photon that has a lower energy that the energy gap between the first and second energy levels.

In a second example, the photon emitter may transition from the first energy level 102 to the second energy level 104 via an intermediate energy level 116 which is higher than the second energy level 104. In this example, the photon emitter absorbs a photon having an energy corresponding to the energy gap between the first energy level 102 and the intermediate energy level 116 enabling the photon emitter to transition 118 from the first energy level 102 to the intermediate virtual energy level 116, and the photon emitter emits a phonon having an energy corresponding to the energy gap between the virtual energy level 116 and the second energy level 104, enabling the photon emitter to transition 120 from the intermediate virtual energy level 116 down to the second energy level 104. Therefore, in this first example, the photon emitter is excited using a photon that has a higher energy that the energy gap between the first and second energy levels.

The transitions between the first and second energy levels can be considered, for example, as the transition of an electron in a quantum dot from the valence band to the conduction band, leaving a hole in the valence band which forms the exciton with the electron. The phonon-assisted transitions occur when the electron absorbs a photon and either absorbs or emits one or more phonons to provide the net amount of energy required for the transition.

Regardless of whether the photon emitter is excited from the first energy level 102 to the second energy level 104 by a zero-phonon transition or a phonon-assisted transition, the probability of the photon emitter decaying back to the first energy level via a zero-phonon transition 108 is higher than the probability of decaying back to the first energy level via a phonon-assisted transition because the direct zero-phonon transition is a first-order process whereas the indirect phonon-assisted transition is a second-order process. Accordingly, using phonon-assisted excitation, it is possible to excite the photon emitter using excitation photons that have an energy (and therefore a wavelength and a frequency) that is different to the energy of the photons that the photon emitter will tend to emit when subsequently decaying back to the ground state.

As a result of such phonon-assisted transitions, the absorption spectrum for the photon emitter will include a central peak corresponding to the absorption of photons triggering the zero-phonon excitation transition 106 and sidebands either side of the central peak corresponding to the absorption of photons triggering the phonon-assisted excitation transitions 112, 118, known as phonon sidebands. The reason the phonon-assisted transitions are represented as extended bands in the absorption spectrum (rather than distinct peaks) is that the phonons can have a range of possible energies, meaning that a range of photon energies can trigger the phonon-assisted transitions.

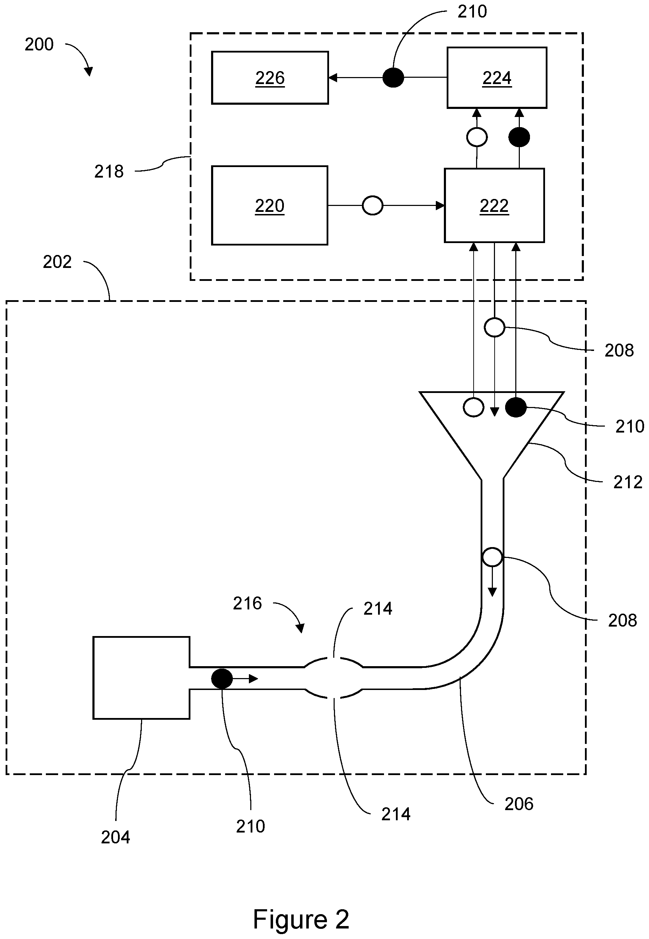

Figure 2 is a schematic diagram of an apparatus 200 for generating single photons. The apparatus comprises a photonic integrated circuit, a part 202 of which is shown in plan view in Figure 2. The apparatus 200 also comprises a photon emitter 204.

The photon emitter may comprise an optical cavity on the photonic integrated circuit into which the quantum dot is placed to enhance the rate of photon emission due to the Purcell effect. The cavity may be configured such that there is a preferential direction in which photons emitted from the photon emitter 204 will tend to leak out of the cavity, which is directly back towards the channel 206 in the example shown in Figure 2.

A single channel 206 is arranged in-plane on the photonic integrated circuit 202. The channel 206 is arranged to direct excitation photons 208 into the photon emitter 204 and to carry away photons 210 emitted from the photon emitter. The channel 206 is arranged between the photon emitter 204 at one end of the channel and an outcoupler 212 at the other end of the channel, which may be, for example, a grating coupler.

In this example, the photon emitter is arranged in the same plane as the single channel, in the sense that the photon emitter and the single channel are formed in the same plane as one another. In this example, the plane in which the single channel and the photon emitter are arranged is the surface of the photonic integrated circuit, in that the photon emitter and the single channel are formed in the surface layer of the photonic integrated circuit.

The single channel may be formed by etching regions of the photonic integrated circuit to remove material on either side of the channel 206. For example, trenches may be etched into the photonic integrated circuit on each side of the channel 206. This leaves the channel 206 as a ridge of material on the photonic integrated circuit, forming an optical waveguide along the photonic integrated circuit through which light can travel. The ridge which forms the channel 206 may also be under-etched such that the channel 206 is suspended above the substrate of the photonic integrated circuit.

To support the suspended channel 206, the photonic integrated circuit may comprise at least one mechanical support. In this example, a mechanical support 214 is provided in the form of one or more supporting struts of unetched material connecting the suspended channel 206 to the surface of the photonic integrated circuit. In this example, two supporting struts 214 are shown, one on either side of the channel 206. Other examples may not include mechanical supports.

To reduce scattering loses which might be caused by the interface between the channel 206 and the mechanical supports 214, the channel comprises a widened portion 216 where the mechanical supports connect to the channel 206. As a light mode travelling along the channel 206 enters the widened portion of the channel, the light mode is modified due to the different dimensions of the channel at the point, making the light mode less sensitive to scattering as it passes the mechanical supports. This increases transmission of photons past the mechanical support. While one such mechanical support and corresponding widened portion are shown in the example of Figure 2, other examples may include multiple mechanical supports and multiple corresponding widened portions of the channel 206.

The outcoupler 212 serves to couple light travelling through the channel 206 to associated pumping and collection photonic components 218 which may be provided 'off-chip' in that these components may be separate from the photonic integrated circuit 202 upon which the channel 206 and photon emitter 204 are provided (e.g., on a separate, connected photonic integrated circuit). For a photon 210 travelling along the channel 206 from the photon emitter 204 towards the outcoupler 212, when the photon 210 reaches the outcoupler 212 the outcoupler will scatter the photon out of the plane of the photonic integrated circuit 202 (i.e., out of the page in Figure 2) towards the associated photonic components 218. For a photon travelling into the plane of the photonic integrated circuit 202, the outcoupler 212 will scatter the photon into the plane of the photonic integrated circuit and along the channel 206 towards the photon emitter 204. Therefore, the arrows in Figure 2 showing photons travelling between the components 218 and the photonic integrated circuit 202 are intended to show photons travelling into and out of the plane. It should be understood that the diagrammatic layout of the photonic components 218 in relation to the photonic integrated circuit 202 in Figure 2 is not intended to limit the spatial relationship between the components 218 and the photonic integrated circuit 202.

The pumping and collection photonic components 218 include a pump laser 220 which generates excitation photons 208 which are represented as white circles in Figure 2. A circulator or highly imbalanced beam splitter (e.g., a 99:1 beamsplitter) 222 is provided to direct the excitation photons 208 from the laser down into the plane of the photonic integrated circuit 202 and onto the outcoupler 212 (i.e., into the page in Figure 2). The outcoupler 212 scatters the excitation photons 208 into the plane of the photonic integrated circuit 202 such that the excitation photons are directed into and along the channel 206 towards the photon emitter 204. Accordingly, the circulator or imbalanced beamsplitter 222 and the outcoupler 212 together form a light coupling structure to direct excitation photons into the channel 206. The excitation photons reaching the photon emitter excite the photon emitter into an excited state. Upon decay to a ground state, the photon emitter emits a single photon 210 into the channel 206, back towards the outcoupler 212.

The outcoupler 212 scatters the photon 210 out of the plane of the photonic integrated circuit 202 (i.e., out of the page in Figure 2), and towards the circulator or imbalanced beam splitter 222. However, because it typically requires more than a single excitation photon 208 (on average) to excite the photon emitter 204, not every excitation photon 208 will trigger an excitation of the photon emitter 204, and some of the pump photons can be reflected or scattered back into the channel 206. Therefore, the output stream of photons returning from the photon emitter 204 to the circulator or imbalanced beam splitter 222 will contain a significant number of the laser excitation photons which will need to be removed.

To solve this problem, the wavelength of the excitation photons 208 is detuned from the zero-phonon excitation and emission wavelength of the photon emitter 204. This may be achieved by selecting a laser with an appropriate wavelength, or by using a tuneable laser with a controllable emission wavelength. Specifically, the wavelength of the excitation photons 210 may be tuned to a phonon sideband excitation wavelength of the photon emitter 204 so as to excite the photon emitter 204 via phonon-assisted transitions as described above with respect to Figure 1. In some examples, the wavelength of the excitation photons 208 is tuned to a phonon sideband excitation wavelength that is longer than the zero-phonon excitation wavelength (in which case, the photons would excite the photon emitter by a phonon-assisted transition similar to transitions 112 and 114 shown in Figure 1) and in other examples the wavelength of the excitation photons 208 is tuned to a phonon sideband excitation wavelength that is shorter than the zero-phonon excitation wavelength (in which case, the photons would excite the photon emitter via a phonon-assisted transition similar to transitions 118 and 120 shown in Figure 1).

In this way, the excitation photons 208 and the single photons 210 emitted from the photon emitter 204 (which will tend to be emitted via the zero-phonon line transition, as described above) will be distinguishable from one another because they will have different wavelengths. Accordingly, the excitation photons 208 can be removed from the output stream from the channel 206 via spectral (i.e., wavelength) filtering. Accordingly, the stream of photons returning to the circulator or imbalanced beamsplitter 222 from the channel 206 are directed onwards to a spectral filter 224 which removes the excitation photons 208, leaving a stream of photons 210 that were emitted from the photon emitter 204. This stream of remaining photons 210 can then be routed to an output 226 of the apparatus, which may be for example a fibre optic output channel.

The apparatus 200 therefore requires only a single channel 206 to carry both the excitation photons 208 to the photon emitter, and to carry away the photons 210 emitted by the photon emitter. This is in contrast to a multi-channel approach in which the pump laser input stream and single photon output stream are confined to separate channels to avoid cross-contamination. The apparatus 200 is therefore more compact, as a single channel apparatus will occupy a smaller footprint than a multi-channel apparatus, and is simpler to manufacture because for each photon emitter 204 it is necessary to etch only a single corresponding channel 206 onto the integrated circuit.

Providing the single channel 206 in-plane on the photonic integrated circuit also gives rise to a number of advantages. Firstly, an in-plane arrangement make it possible to couple an array of photon emitters to an array of optical fibres, because the individual waveguide routing can be used to ensure the outcouplers have the same alignment as the fibres in the array, unlike with other structures such as an out-of-plane micropillar structure.. Secondly, standard fibre packaging components (such as fibre couplers) are typically designed for in-plane photonic components, meaning that the in-plane channel 206 of the apparatus 200 can be integrated more readily with existing fibre packaging, unlike other structures such as micropillars which require bespoke fibre packaging components due to the need for the excitation and emission waveguides to be arranged out of the plane of the photonic integrated circuit.

In the example shown in Figure 2, the single channel 206 is curved. Specifically, the curvature of the single channel is such that the direction in which the photons emitted by the photon emitter enter the single channel is substantially perpendicular to the direction in which those photons exit the single channel. While this arrangement is advantageous, in other examples the single channel may instead be straight between the photon emitter 204 and the outcoupler 212.

The advantage provided by the curved channel 206 is to make the photonic integrated circuit 202 compatible with polarisation filtering to distinguish the excitation photons 208 from the photon 210 emitted from the photon emitter 204. If using polarisation filtering, spectral filtering is not required, meaning that it is not necessary to detune the pump laser from the zero-phonon excitation wavelength. This can be useful for testing the performance of the photon emitter using lab-grade microscopes which implement polarisation filters.

In the polarisation filtering implementation, the photon emitter 204 is pumped using a laser positioned over the photon emitter 204, such that the photon emitter is excited by a stream of excitation photons directed into the plane of the photonic integrated circuit 202 (i.e., into the page in Figure 2), rather than sending excitation photons along the channel 206. A polarisation filter is positioned over the photon emitter 204, to intercept the excitation photon stream from the pump laser before it reaches the photon emitter, such that the polarisation of the excitation photons is selected by the filter. The photon emitter will be excited by the excitation photons, and decay to release a photon 210 into the single channel 206, which travels along the single channel towards the outcoupler 212. The polarisation of the photons 210 emitted by the photon emitter depends on the design of the cavity in which the photon emitter 204 is placed, and this polarisation may be chosen to be the same as the polarisation of the excitation photons. Because the path of the channel 206 is curved, the polarisation of the photon 210 will be modified as it travels along the curve. Specifically, as the curvature of the channel is such that the direction in which the photons emitted by the photon emitter enter the single channel is substantially perpendicular to the direction in which those photons exit the single channel, the polarisation of the photons will change from, for example, a vertical polarisation when the photons enter the channel to a horizontal polarisation when the photons exit the channel at the outcoupler 212 (or vice versa). This means that any excitation photons that are inadvertently scattered into the collection components can be distinguished from the photons 210 emitted by the photon emitter leaving the channel 206 by polarisation filters, because the emission photons 210 will have a polarisation when leaving the channel 206 that is different to the polarisation of any scattered pump photons. In this case, the wavelength of the pumping and emission photons need not be detuned.

The above embodiments are to be understood as illustrative examples. Further embodiments are envisaged.

In particular, while Figure 2 shows a single photon emitter 204 and a corresponding single channel 206, in other examples the apparatus may comprise an array of photon emitters and an array of channels, each channel corresponding to a different one of the photon emitters.

While Figure 2 shows the channel 206 as a waveguide formed on the photonic integrated circuit, in other examples the channel 206 may be provided as a free space path, with the corresponding collection and pumping components replaced with corresponding free space optics.

Different materials can be used for the photon emitters. Examples include: a photon emitter formed of InAs hosted in a GaAs lattice; a photon emitter forms of InAs hosted in a InP lattice; and a photon emitter formed of GaAs in an AlGaAs lattice. An advantage of hosting the photon emitter in a GaAs, InP or AlGaAs lattice is that longitudinal acoustic phonons are typically in the range of a few meV, which are well suited for enabling phonon-assisted energy level transitions in the photon emitter. Using these material systems, typically around 90% of photons are emitted via the zero-phonon transition at low temperature (e.g., 4 K), and around 10% of photons are emitted via the phonon sideband. It is to be understood that any feature described in relation to any one embodiment may be used alone, or in combination with other features described, and may also be used in combination with one or more features of any other of the embodiments, or any combination of any other of the embodiments. Furthermore, equivalents and modifications not described above may also be employed without departing from the scope of the invention, which is defined in the accompanying claims. These claims are to be interpreted with due regard for equivalents.

Reference numerals appearing in the claims are by way of illustration only and shall have no limiting effect on the scope of the claims.

## Claims

1. An apparatus comprising:
a photonic integrated circuit comprising:
a photon emitter, and
a single channel, arranged in-plane on the photonic integrated circuit, and arranged to direct excitation photons into the photon emitter and to carry
away photons emitted from the photon emitter,
wherein the wavelength of the excitation photons is detuned from the zero-phonon excitation and emission wavelength of the photon emitter.

2. An apparatus according to Claim 1, wherein the wavelength of the excitation photons is tuned to a phonon sideband excitation wavelength of the photon emitter.

3. An apparatus according to any preceding claim, comprising a light coupling structure to direct the excitation photons into the single channel and/or to direct the photons emitted from the photon emitter from the single channel to an output of the photonic integrated circuit.

4. An apparatus according to Claim 3, wherein the light coupling structure comprises a circulator or an imbalanced beam splitter.

5. An apparatus according to Claim 3 or 4, wherein the light coupling structure comprises:
an outcoupler; an edge coupler; or an evanescent coupler.

6. An apparatus according to Claim 5, wherein the single channel comprises the outcoupler, edge coupler, or evanescent coupler.

7. An apparatus according to any preceding claim, comprising a spectral filter for wavelength filtering of photons output from the single channel, for example wherein the spectral filter is separate from the photonic integrated circuit.

8. An apparatus according to any preceding claim, wherein the excitation photons are laser photons, for example wherein the excitation photons are laser photons from a pump laser.

9. An apparatus according to any preceding claim, comprising an optical cavity, in which the photon emitter is located, arranged to direct photons emitted from the photon emitter into the single channel, preferably wherein the optical cavity is on the photonic integrated circuit.

10. An apparatus according to any preceding claim, wherein the single channel is curved.

11. An apparatus according to Claim 10, wherein the curvature of the single channel is such that the direction in which the photons emitted by the photon emitter enter the single channel at one end of the single channel is substantially perpendicular to the direction in which those photons exit the single channel at the other end of the single channel.

12. An apparatus according to any preceding claim, wherein the single channel is suspended upon the surface of the photonic integrated circuit, preferably comprising at least one mechanical support to support the suspended single channel, wherein the single channel comprises a widened portion at an interface between the single channel and the at least one mechanical support.

13. An apparatus according to any preceding claim, wherein the photon emitter is formed as a quantum dot, preferably an epitaxial quantum dot, embedded in a host lattice, for example wherein the quantum dot is formed from: InAs; or GaAs, and/or wherein the host lattice is formed from: GaAs; InP; or AlGaAs.

14. A system comprising:
an apparatus according to any preceding claim; and
a laser configured to generate the excitation photons.

15. A method for generating photons, comprising:
directing, through a single channel arranged in-plane on a photonic integrated circuit, excitation photons into a photon emitter;
carrying away, through the single channel, photons emitted from the photon emitter; and
detuning the wavelength of the excitation photons from the zero-phonon excitation wavelength of the photon emitter.
